(19) Europäisches Patentamt
European Patent Office
Office européen des brevets

(11) EP 3 422 575 A1

(12) EUROPEAN PATENT APPLICATION

(43) Date of publication:
02.01.2019 Bulletin 2019/01

(51) Int Cl.:
$H03K\ 17/12^{(2006.01)}$

(21) Application number: 17460037.9

(22) Date of filing: 28.06.2017

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(71) Applicant: ABB Schweiz AG
5400 Baden (CH)

(72) Inventors:
• Ruszczyk, Adam
30-316 Krakow (PL)
• Koska, Krzysztof
31-960 Krakow (PL)

(74) Representative: Chochorowska-Winiarska, Krystyna
ABB Sp. z o. o.
ul. Zeganska 1
04-713 Warszawa (PL)

(54) METHOD OF ELECTRICAL BURDEN SHARING BETWEEN A NUMBER OF PARALLEL CONNECTED AC SOLID-STATE SWITCHES

(57) The invention relates to the method of electrical burden sharing between a number of parallel connected AC solid-state switches in a system that connects a load to a power source. A method according to the invention is **characterized in that** after execution an initial step of determining an initial status St1..Stn of each switch 21..2n, a step of measuring temperature of each switch 21..2n in a periodic time cycle is introduced for excluding from the operation the switch having the hottest temperature.

Fig. 1

EP 3 422 575 A1

**Description**

The invention relates to the method of electrical burden sharing between a number of parallel connected AC solid-state switches in a system that connects a load to a power source. The invention can be utilized in UPS (Uninterruptable Power Supply) systems.

The parallel connected switches operate in the condition where a total current conducted to the load is higher than a current capacity of a single switch. The imbalance in sharing of current conducted by parallel connected switches is a reason of not equal burden sharing between switches. That, in consequence, provides to the overload, overheat and failure of the most loaded switch. Problem is especially important when parallel operating switches are characterized by the negative thermal coefficient of their internal resistance. The negative thermal coefficient causes the resistance of the switch is becomes to be lowering when its temperature rises. It causes forward increase of the imbalance of current and burden sharing.

Background of the invention.

A systems, having several parallel connected solid-state switches (semiconductors) in order to extend total current rating in comparison to a single switch capability, are well known from the prior art. The Static Bypass Switch (SBS) or Static Transfer Switch (STS) is a typical application of solid-state AC switches in the systems with Uninterruptable Power Supply (UPS). Power rating of such devices can easily reach few megawatts range. As a result, in low voltage systems (3x400V), the current rating of the switch should be in a several kA range which is at the edge of semiconductor technology capabilities, mainly due to the limit of heat transfer from a single semiconductor device. The growth of demanded power rating leads to design of solid-state switches in form of parallel connected semiconductor devices. This approach should increase total current rating of solid-state switch. The well-known practical realization of the AC solid-state switch consists of two thyristors connected in anti-parallel manner. The thyristor is a main choice among the semiconductor devices due to its advantages such as:

- low forward voltage drop (low conduction losses),
- symmetric revers blocking voltage (single device in current conduction path),
- high overcurrent capability (inrush pulse current withstand).

The biggest technical challenge in parallelization of such AC switches is to ensure equal burden sharing between parallel branches. Usually, it is interpreted as equal current sharing between particular branches with AC switches.

There are several reasons influencing on the current distribution between parallel branches:

- Semiconductor's parameters deviation at manufacturing level - every semiconductor has some differences in forward voltage threshold and slope of dynamic resistance,

- A single branch impedance variation-the conduction path consists not only a lumped impedance, but as well as numerous parasitic impedances of connections that are hard to predict, calculate and tune.

- Differences in a cooling system performance - parameters of semiconductor switches are sensitive to temperature change. It is difficult to keep several distributed semiconductor switches in the same temperature condition.

- The negative thermal coefficient of internal resistance of the semiconductor switch which, in some situations, causes thermal runaway due to destructive positive feedback.

In general, the main limiting factor for parallel connected AC switches is the temperature of the hottest semiconductor switch in the whole system. When a single semiconductor switch reaches its maximum temperature then all switches in the device must be turned-off in order to omit "a domino effect" following to the catastrophic failure of all semiconductor elements. Therefore the performance of whole AC switch is rated for the worst condition in which unbalanced current causes the overheating of a single device that is reaching its maximal allowable temperature. The total current carrying capability of a AC switch made as parallel connected devices is defined by the maximal temperature of the hottest one switch in their parallel setup.

From US patent US 2011/0109297 there is known solution of parallel switches arranged to transfer power between an AC power source and a load. The main idea described in this patent is that all switches may be individually operated during different portions of the AC waveform.

In some embodiments, the switches may be operated during alternate cycles of the waveform to cause the individual switches to sequentially conduct the entire load current. According to the patent description an embodiment of a circuit may have two or more switches that are arranged in parallel between an AC power source and a load. A controller generates control signals to provide individual control of the switches so that the individual switches may operate during different portions of the AC waveform. For example, the controller may operate the switches sequentially during alternating cycles or half-cycles of the AC Waveform. The controller may be implemented with analog or digital hardware, software, firmware, or any suitable combination thereof. Controller utilizes the pattern of control signals to operate switches in sequential order and to balance burden between switches in this manner. The disadvantages of this solution are the following:

- the pattern of control signals for switches is not dependent of changing parameters of real device or performance of its cooling system,

- every switch conducts current alone that eliminate big advantage of parallel connected switches - simultaneous conduction in overcurrent condition (short-circuit, inrush current).

An essence of the inventive method is that, after an execution of an initial step for determining by a user an initial status St1..St$n$ of each switch 21..2$n$ that is performed in a main controller, a step of measuring temperature of each switch 21..2$n$, in a periodic time cycle given by the user, is introduced for excluding from the operation the switch having the highest temperature for which a maximum temperature $T_{max}$ is calculated in this periodic time cycle. When the temperature $T_{max}$ of the hottest switch is higher than the sum of a reference temperature $T_{ref}$ and a tolerance temperature $T_{tol}$ given by the user, a flag signals Fl1..Fl$n$ relevant to switches 21..2$n$ are calculated what is performed in an auxiliary controller. Flag signals Fl1..Fl$n$ are representing information about that which switch is the hottest and if the hottest switch has to be excluded from operation. Next new control signals Cs1..Cs$n$ are calculated based on initial status St1..St$n$ and flag signals Fl1..Fl$n$ according to the formula described as a logical relation:

$$\{Cs1..Csn\} = [\ \{St1..Stn\} \wedge \{Fl1..Fln\}\ ].$$

The new control signals Cs1..Cs$n$ are sent to all switches for taking the "on" or "off" action of relevant switches. When the temperature $T_{max}$ of the hottest switch is higher than the sum of a reference temperature $T_{ref}$ and a tolerance temperature $T_{tol}$ the new control signals Cs1....Cs$n$ are sent to all switches for taking the "off" action for the hottest switch and for taking the "on" action for all remaining switches. When the temperature $T_{max}$ is lower than a sum of a reference temperature $T_{ref}$ and a tolerance temperature $T_{tol}$ the new control signals Cs1....Cs$n$ are sent to all switches for taking the "on" action and next the step of measuring the temperature of each switch 21..2n in a next periodic time cycle is performed.

Preferably the reference temperature $T_{ref}$ is determined by user using the one of the known method as calculation of the average temperature of all switches, calculation of the average temperature or all switches except the hottest one, calculation of the median temperature, selection of the temperature of the coldest switch, selecting from a look-up table or given as constant value.

Preferably the step of determining the temperature of each switch is performed by measuring the temperature by sensors directly placed at each switch.
Alternatively the step of determining the temperature of each switch is performed by measuring the temperature by sensors indirectly were sensors are placed at thermo-conductive elements connected to each switch.

An essence of the inventive system having at least two parallel connected switches, connected between a power source and a load creating together a closed electric circuit, wherein each of the switches is connected with a main controller, is that each of the switch is equipped with temperature measuring means. Each of the switches is connected with an auxiliary controller which is a computer device equipped with an auxiliary processor, an auxiliary memory with a calculation module for receiving and processing temperature feedback signals Ts1..Ts$n$ from switches and with a flag calculation module for calculating flag signals Fl1..FL$n$. The auxiliary controller is connected with the main controller which comprises a calculation module for processing the flag signals Fl1..FL$n$ and an execution module for switching off the switch having the highest temperature determined by flag signals Fl1..FL$n$ and performed by status signals Cs1..Cs$n$.

Preferably the AC solid-state switches have a form of semiconductors.

Alternatively the AC solid-state switches have a form of two unidirectional switches connected in anti-parallel manner.

Preferably unidirectional switches have a form of thyristors or transistors.

Preferably temperature measuring means are temperature sensors directly placed at each switch.

Alternatively temperature measuring means are temperature sensors indirectly placed at each switch and having a form of temperature sensors directly placed at thermo-conductive elements connected to each switch.

A computer program product for the method of electrical burden sharing between a number of parallel connected AC solid-state switches connected between a power source and a load creating together a closed electric circuit, which the computer program product is loadable into and executable in a main controllers and an auxiliary controller, characterized in that during program run it executes the method according to claim 1 through 4.

The advantage of the invention is its easy application into the existing solution just by a simple modification of the controller. This solution does not require any changes in power system of the electric circuit and do not introduce additional lossy components to the current conducting path but requires only a temperature sensing means independent for every AC switch and a modulation of control signals of each AC switch. For protection or to improve the burden sharing quality the additional voltage and/or current sensor can be utilized. By implementation of an auxiliary controller the burden sharing can be achieved without interfering with main controller structure.

The inventive method is presented as an embodiment in the drawing where:

Fig. 1     shows the system for the execution of the inventive method,

Fig. 2     shows the detail from Fig.1 in another embodiment of the invention,

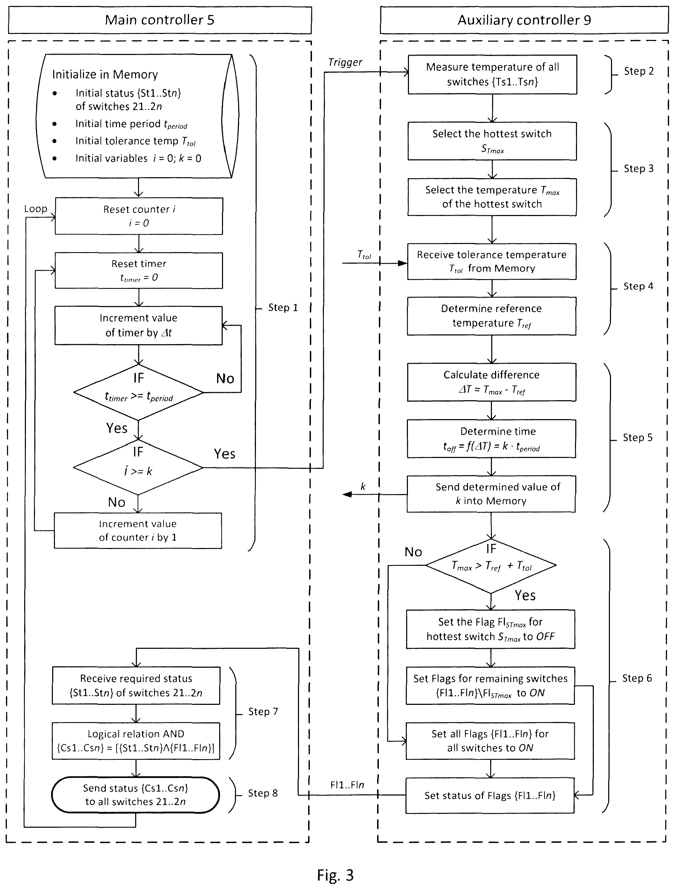

Fig. 3     shows a flow chart of the method according to presented invention.

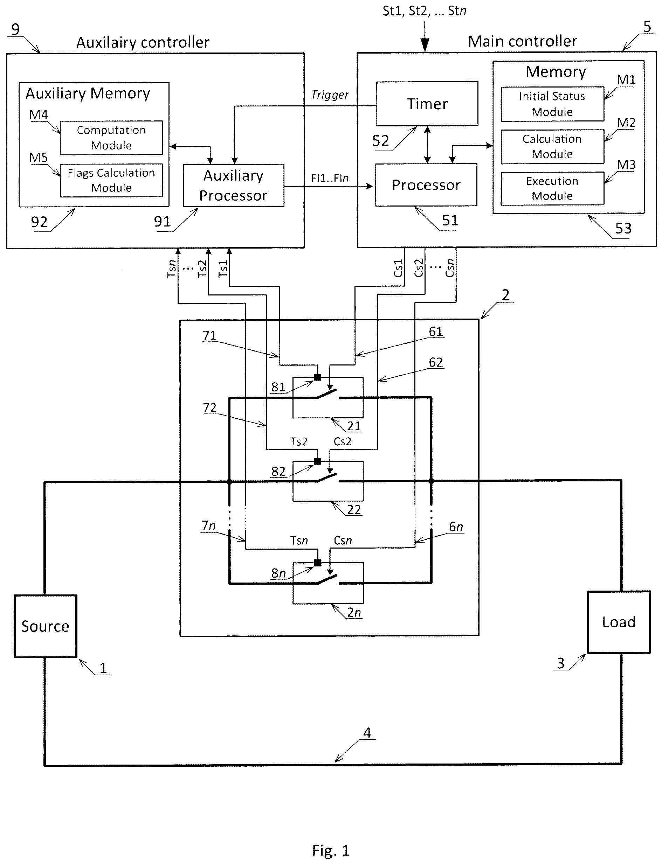

According to Fig. 1 the power source 1 is connected to the solid-state switches 21...2$n$ ($n$ is a natural number), having a form of semiconductors, which are connected in parallel together and in series to the load 3, creating together with the power source 1 a closed electric circuit 4. A main controller 5 is connected to the solid-state switches 21...2$n$ by control signal connectors 61...6$n$ transferring control signals Cs1...Cs$n$ to the switches 21...2$n$, respectively, which allow for opening or closing a suitable switch or switches. The main controller 5 is a computer device comprising a processor 51 with a timer 52 and a memory 53 with a number of functional modules like an initial status module M1 for initializing and performing the method according to the invention and a calculation module M2 for logic calculation of control signals Cs1...Cs$n$ and an execution module M3 transferring the control signals Cs1...Cs$n$ to the switches 21...2$n$. Each of the solid-state switches 21...2$n$ is equipped with their own temperature sensor 81..8$n$, respectively, for measuring the temperature of each of the solid-state switch 21...2$n$. Each of the solid-state switches 21...2$n$ is connected by feedback signal connectors 71...7$n$ with an auxiliary controller 9 to which temperature feedback signals Ts1...Ts$n$ are transmitted. The auxiliary controller 9 is an external computer device comprising an auxiliary processor 91 and an auxiliary memory 92 with a number of functional modules like a computation module M4 for processing the relevant computation steps according to the invention and a flags calculating module M5 for calculation of flag signals Fl1..Fl$n$ necessary for modification of the control signal Cs1..Cs$n$ to control the switches according to the invention. The auxiliary controller 9 can be implemented as a part of the main controller 5, that is not presented in the drawings. In the auxiliary controller 9 the temperature feedback signals Ts1...Ts$n$, informing about the temperature of the switches, are analyzed and the result of analysis in a form of flag signals Fl1..Fl$n$ is sent to the main controller 5 in order to control the status of the control signal Cs1..Cs$n$ and next to close or open the suitable switch or switches 21...2$n$, respectively. Number of $n$ parallel connected switches is calculated as $n = m + p$, where $m$ is a number of switches that are required to be connected in parallel to conduct load current under assumption the current is equally shared between $m$ switches, while $p$ is a number of redundant switches used for balancing and $p$ is at least equal 1.

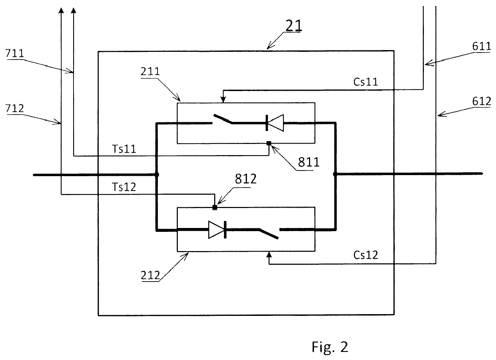

In other embodiment of the invention any of switches 21...2$n$ can be replaced by two unidirectional switches e.g. 211 and 212 connected in anti-parallel manner that is presented in fig. 2. In that instance each unidirectional switch may have independent control signal, for example Cs11, Cs12 delivered to the switches 211 and 212 by control signal connectors 611 and 612 and independent temperature feedback signal, for example Ts11, Ts12, for transferring it to the auxiliary controller 9 by feedback signal connectors 711 and 712. At least one of switches 21...2$n$ could be replace by at least one switch 211...21$n$ or all switches 21...2$n$ could be replace by switches 211...21$n$ . In practical realization each unidirectional switch can be considered as made of semiconductor device like thyristor or transistor or other similar type of semiconductor device known for technically skilled person.

An example of the inventive method is presented in the following steps S1-S8.

Step S1

In the step S1, in the memory 53 of main controller 5, the initial status module M1 initializes required status of the switches 21..2$n$. The initial status of the switches 21..2$n$ is defined by user as St1..St$n$. The initial status St1..St$n$ of switches 21..2$n$ is described by their logic value "1" for closed switch in the state "on" and logic value "0" for open switch in the state "off" (or vice versa because the logic value has only a contractual meaning). Simultaneously, the module M1 initializes a control time period $t_{period}$ for triggering the periodic measurement of the temperature of the switches and

a temperature tolerance $T_{tol}$ value for defining a tolerance band of temperature and vale of a counter $i$ and an auxiliary variable $k$ for controlling an intensity of an electric burden balancing method. The time period $t_{period}$ and the temperature tolerance $T_{tol}$ are established by user. In presented solution the time period $t_{period}$ is equal to the AC source time period. The counter $i$ is the cycle's counter and is reset to zero $i = 0$. A timer $t_{timer}$ value is set in the timer 52 to zero, $t_{timer} = 0$, and the timer 52 is initialized and set to run to count the time $t_{timer}$ by incrementing its value by $\Delta t$ value. The $\Delta t$ value is an increment of time define by the user and dependent on the timer 52 structure that is commonly known for skilled person. The timer runs until reach a condition $t_{timer} >= t_{period}$. Than next the condition for $i >= k$ is checked. If the condition is fulfilled the next step S2 is performed. If the condition is not fulfilled counter $i$ is incremented and iterative loop starts from setting timer value to zero $t_{timer} = 0$.

Step S2

In the step S2 a measurement of temperature of each switch 21..2$n$ is performed by sensors 81..8$n$ and temperature feedback signals Ts1..Ts$n$ are transmitted to the auxiliary controller 9. In practical realization temperature of each switch can be directly measured by temperature sensor at switch casing or indirectly measured by temperature sensor at thermoconductive element connected with switch casing or estimated based on current and / or voltage measured at the switch and calculation of a thermal model of the switch. The thermal model of the switch is a system well known from literature or manufacturers documentation.

Step S3

In the step S3, the hottest switch is selected by the computation module M4 of the auxiliary controller 9. Based on temperature feedback signals Ts1..Ts$n$ of each of solid-state switches 21..2$n$, the hottest switch $S_{Tmax}$ having a maximum temperature $T_{max}$ is selected and its temperature $T_{max}$ is registered by the computation module M4 in auxiliary memory 92 of auxiliary controller 9.

Step S4

In the step S4, the tolerance temperature $T_{tol}$ determined by user in the step S1, is received from the memory 53 of the main controller 5. A reference temperature $T_{ref}$ is determined by computation module M4. The reference temperature $T_{ref}$ can be determined by using one of the know method for example:

- the calculation of the average temperature of all switches,

- the calculation of the average temperature or all switches except the hottest one,

- the calculation of the median temperature,

- the selection of the temperature of the coldest switch,

- given by a user as a constant (invariable) value

- or obtained by any known similar method.

Step S5

In the step S5, in the computation module M4 an increment of temperature $\Delta T$ of the maximum temperature $T_{max}$ of the hottest switch $S_{Tmax}$ to the reference temperature $T_{ref}$ is calculated according to the formula:

$$\Delta T = T_{max} - T_{ref} \tag{1}$$

Next, in the computation module M4, time $t_{off}$ of excluding of the hottest switch $S_{Tmax}$ is determined for which the hottest switch $S_{Tmax}$ will stay open in "off" state (logic "0"). The value of time $t_{off}$ is determined as a function of the calculated increment of temperature $\Delta T$.

$$t_{off} = f(\Delta T) = k \cdot t_{period} \tag{2}$$

where:

$k$ is natural number and means the number of cycles that timer 52 has to iterate in the step S1. In the simplest form this function can be proportional and time $t_{off}$ is fixed as the $k$ cycles of time period $t_{period}$. The calculated value of $k$ is stored in memory 53 of the main controller 5.

Step S6

In the step S6 a comparison of the value of the maximum temperature $T_{max}$ with reference temperature $T_{ref}$ plus the tolerance temperature $T_{tol}$ is performed in order to mark all flag signals Fl1..Fl$n$ for all switches to be closed in "on" state (logic "1") or to mark the flag for the hottest switch to be open in "off" state (logic "0") and to mark all remaining flags to be close in "on" state (logic "1"). This action is realized in the flags calculation module M5 of the auxiliary memory 92 of the auxiliary controller 9 in the following manner:

- if $T_{max} > (T_{ref} + T_{tol})$ that means the hottest switch $S_{Tmax}$ has to be open to "off" state (logic "0"), while the rest of switches have to remain in their state defined by initial status signals St1..St$n$ of the main controller 5 either open in "off" state (logic "0") or closed in "on" state (logic "1"). Therefore a flag $Fl_{STmax}$ of the hottest switch is assigned to the hottest switch $S_{Tmax}$ and value of the flag $Fl_{STmax}$ is set to "0" that is representing an open "off" state (logic "0"), while all remaining flags are set to "1" representing closed "on" state (logic "1") of the switch,
- if $T_{max} \leq (T_{ref} + T_{tol})$ that means all parallel connected solid-state switches 21..2$n$ have to remain in their state defined by initial status signals St1..St$n$ of the main controller 5 either open in "off" state (logic "0") or closed in "on" state (logic "1"). Therefore all flag signals Fl1..Fl$n$ assigned to all switches 21..2$n$ are set to logic value "1".

The information about flag signals Fl1..Fl$n$ for the switches is transferred to the main controller 5 in order to update the present status of all solid-state switches 21..2$n$ to the required one.

Step S7

In the step S7, in the calculation module M2 of main controller 5 a logical relation "AND" is performed for all flag signals Fl1..Fl$n$ and for all required status signals St1..St$n$ according to the formula:

$$\{Cs1..Csn\} = [\, \{St1..Stn\} \wedge \{Fl1..Fln\} \,] \tag{3}$$

The result of this logical relation sets new values to control signals Cs1..Cs$n$. From that moment the control signals Cs1..Cs$n$ carry the revised information about which switch 21..2$n$ has to be open in "off" state (logic "0") and which has to be closed in "on" state (logic "1").

Step S8

In the step S8, in the execution module M3 new control signals Cs1..Cs$n$ are sent to the switches 21..2$n$ and switches take states required to balance electric burden between parallel connected solid-state switches 21..2$n$. This state, when the hottest switch of the parallel connected solid-state switches 21..2$n$ is turned off, remains for $k$ cycles of $t_{period}$ and balancing effect of electrical burden sharing is reached. As a result the temperature of the hottest element will be reduced and temperature of all other elements will increase. And next iterative cycle loop starts from reset counter $i$ to zero $i = 0$.

The method of electrical burden sharing between a number of parallel connected AC solid-state switches is basing on the measurements of their temperatures. It means that the switch having the lowest temperature should carrying more current than the hotter one and the same way the hottest switch should carrying less current than the cooler one. To control a burden sharing between parallel connected switches the hottest switch should be turned-off for selected period of time that allows it to cool down while the other parallel connected switches are stronger loaded conducting additional current taken over from turned-off switch that should heat them up. In practice, the averaged current shared between parallel connected switches does not have to be equal in each parallel branch, but reflects the switch losses and the cooling system ability to heat transfer in each parallel switch individually.

**Claims**

1. A method of electrical burden sharing between a number of parallel connected AC solid-state switches (21..2*n*) connected between a power source (1) and a load (2) creating together a closed electric circuit (4), where a main controller (5) is connected to each switch, **characterized in that** after execution of an initial step for determining by a user an initial status St1..St*n* of each switch (21..2*n*) that is performed in a main controller (5), a step of measuring temperature of each switch (21..2*n*), in a periodic time cycle given by the user, is introduced for excluding from the operation the switch having the highest temperature and for which a maximum temperature $T_{max}$ is calculated in this periodic time cycle; and when the temperature $T_{max}$ of the hottest switch is higher than the sum of a reference temperature $T_{ref}$ and a tolerance temperature $T_{tol}$ given by the user, a flag signals Fl1..Fl*n* relevant to switches (21..2*n*) are calculated what is performed in an auxiliary controller (9); where flag signals Fl1..Fl*n* are representing information about that which switch is the hottest and if the hottest switch has to be excluded from operation, and next new control signals Cs1..Cs*n* are calculated based on initial status St1..St*n* and flag signals Fl1..Fl*n* according to the formula described as a logical relation:

$$\{Cs1..Csn\} = [\ \{St1..Stn\} \wedge \{Fl1..Fln\}\ ]$$

and next new control signals Cs1..Cs*n* are sent to all switches (21..2*n*) for taking the action "off" for said hottest switch and for taking the action "on" for all remaining switches when the temperature $T_{max}$ of the hottest switch is higher than a sum of a reference temperature $T_{ref}$ and a tolerance temperature $T_{tol}$ or for taking the action "on" for all switches (21..2*n*) when the temperature $T_{max}$ of the hottest switch is lower than the sum of a reference temperature $T_{ref}$ and a tolerance temperature $T_{tol}$, and next the step of **measuring** the temperature of each switch 21..2*n* in a next periodic time cycle is performed.

2. A method according to claim 1, **characterized in that** the reference temperature $T_{ref}$ is determined by a user using one of the known method as a calculation of the average temperature of all switches, or a calculation of the average temperature of all switches except the hottest one, or a calculation of the median temperature, or a selection of the temperature of the coldest switch, or by selecting it from a look-up table, or given as a constant value.

3. A method according to claim 1, **characterized in that** the step of determining the temperature of each switch is performed by measuring the temperature by sensors (81..8*n*) directly placed at each switch (21..2*n*).

4. A method according to claim 1, **characterized in that** the step of determining the temperature of each switch is performed by measuring the temperature by sensors (81..8*n*) indirectly were sensors are placed at thermo-conductive elements connected to each switch (21..2*n*).

5. A system for electrical burden sharing between a number of parallel connected AC solid-state switches comprises at least two parallel connected switches (21..2*n*) connected between a power source (1) and a load (2) creating together a closed electric circuit (4), wherein each of the switches (21..2*n*) is connected with a main controller (5), **characterized in that** each of the switch (21..2*n*) is equipped with temperature **measuring** means (81..8*n*), respectively, and each of the switches (21..2n) is connected with an auxiliary controller (9) which is a computer device equipped with an auxiliary processor (91) an auxiliary memory (92) with a calculation module (M4) for receiving and processing temperature feedback signals Ts1..Ts*n* from switches (21..2*n*) and with a flag calculation module (M5) for calculating flag signals Fl1..FL*n*; and the auxiliary controller (9) is connected with the main controller (5) which comprises a calculation module (M2) for processing the flag signals Fl1..FL*n* and an execution module (M3) for switching off one of the switches (21..2*n*) having the highest temperature determined by flag signals Fl1..FL*n* and performed by status signals Cs1..Cs*n*.

6. The system according to claim 5, **characterized in that** the AC solid state switches (21..2*n*) have a form of semiconductors.

7. The system according to claim 5, **characterized in that** the AC solid state switches (21..2*n*) have a form of two unidirectional switches (211...21*n*) connected in anti-parallel manner.

8. The system according to claim 7, **characterized in that** unidirectional switches have a form of thyristors or transistors.

9. A system according to claim 5, **characterized in that** temperature measuring means (81..8$n$) are temperature sensors directly placed at each switch (21..2$n$).

10. A system according to claim 5, **characterized in that** temperature measuring means (81, 82, ...8n) are temperature sensors indirectly placed at each switch (21..2$n$) and having a form of temperature sensors directly placed at thermo-conductive elements connected to each switch.

11. A computer program product for the method of electrical burden sharing between a number of parallel connected AC solid-state switches (21..2$n$) connected between a power source (1) and a load (2) creating together a closed electric circuit (4), which the computer program product is loadable into and executable in a main controller (5) and an auxiliary controller (9), **characterized in that** during program run it executes the method according to claim 1 through 4.

Fig. 1

Fig. 2

Fig. 3

Europäisches
Patentamt

European
Patent Office

Office européen
des brevets

## EUROPEAN SEARCH REPORT

Application Number

EP 17 46 0037

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 724 643 B1 (GIBBS IRVING A [US]) 20 April 2004 (2004-04-20) * column 2, line 35 - column 12, line 4; figures 1-5b * | 1-11 | INV. H03K17/12 |
| X | US 6 614 639 B1 (GIBBS IRVING A [US]) 2 September 2003 (2003-09-02) * column 1, line 18 - column 8, line 37; figures 1-5 * | 1-11 | |
| A,D | US 2011/109297 A1 (TOSUNTIKOOL NAM [US]) 12 May 2011 (2011-05-12) * the whole document * | 1-11 | |
| A | DE 10 2010 034990 A1 (ABB AG [DE]) 23 February 2012 (2012-02-23) * the whole document * | 1-11 | |

| | TECHNICAL FIELDS SEARCHED (IPC) |
|---|---|
| | H03K |

The present search report has been drawn up for all claims

| Place of search | Date of completion of the search | Examiner |
|---|---|---|
| The Hague | 20 December 2017 | João Carlos Silva |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

   .......................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 17 46 0037

This annex lists the patent family members relating to the patent documents cited in  the above-mentioned European search report.
The members are as contained in the European Patent Office EDP file on
The European Patent Office is in no way liable for these particulars which are merely given for the purpose of information.

20-12-2017

| Patent document cited in search report | | Publication date | Patent family member(s) | | Publication date |
|---|---|---|---|---|---|
| US 6724643 | B1 | 20-04-2004 | NONE | | |
| US 6614639 | B1 | 02-09-2003 | NONE | | |
| US 2011109297 | A1 | 12-05-2011 | CA<br>US | 2720196 A1<br>2011109297 A1 | 09-05-2011<br>12-05-2011 |
| DE 102010034990 | A1 | 23-02-2012 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110109297 A